# DEMANDE DE BREVET EUROPEEN

(11) **EP 4 390 563 A1**
(43) Date de publication de la demande: **26.06.2024**
(21) Numéro de dépôt: 23220049.3
(22) Date de dépôt: 22.12.2023
(51) Int. Cl.: G04B 19/30, G04G 17/02, G04C 10/02, G04G 9/00, G04G 17/04, G04G 19/10

(54) **DISPOSITIF DE DÉTERMINATION DE LA POSITION D'UNE AIGUILLE D'UNE MONTRE**

(30) Priorité: 22.12.2022 EP 22215943
(71) Demandeur: ETA SA Manufacture Horlogère Suisse, 2540 Grenchen (CH)
(72) Inventeur: DUBUGNON, Dominique, 1162 Saint-Prex (CH); TORTORA, Pierpasquale, 2000 Neuchâtel (CH); HUOT-MARCHAND, Sylvain, 2743 Eschert (CH); COURVOISIER, Raphaël, 2035 Corcelles (CH)
(74) Mandataire: ICB SA

(57) **Abrégé**

Un aspect de l'invention concerne un cadran (2a, 2b) de montre (1) comprenant un dispositif de détermination (3) de la position d'au moins une aiguille (24a, 24b) de cette montre (1), un tel cadran (2a, 2b) comprend une face visible (20a) et une face cachée (20b) ledit cadran (2a, 2b) étant formé par un empilement (9a, 9b) de couches minces (10, 11, 12, 13, 14) de matière s'étendant entre ces deux faces (20a, 20b), chacune desdites couches (10, 11, 12, 13, 14) comprenant un ou plusieurs des éléments fonctionnels compris dans ledit dispositif de détermination (3) :
- au moins un élément de détection de lumière (23),
- au moins une première source lumineuse (4a) et au moins une deuxième source lumineuse (4b),
- une unité d'alimentation électrique autonome (21) comprenant un module photovoltaïque (5), et
- une unité de contrôle (7) pour gérer le fonctionnement de chaque une source lumineuse (4a, 4b) et dudit au moins un élément de détection de lumière (23).

## Description

### Domaine technique de l'invention

La présente invention concerne une montre comprenant un cadran doté d'un dispositif de détermination de la position d'au moins une aiguille de cette montre, un tel dispositif étant autonome.

### Arrière-plan technologique

Dans l'art antérieur, on connaît des montres électromécaniques à aiguilles dans lesquelles l'aiguille des heures et l'aiguille des minutes d'affichage de l'heure courante sont entraînées par des rouages d'un mécanisme d'un mouvement horloger. Dans ce contexte, il peut arriver qu'en raison des chocs subis par la montre, de la présence de champs électromagnétiques ou d'autres perturbations externes le fonctionnement du mécanisme s'en trouve perturbé. Ceci a pour conséquence que, bien que l'horloge interne de la montre fournisse une indication juste de l'heure courante, les aiguilles d'heures et de minutes fournissent une indication faussée de cette heure courante sous l'effet de la perturbation externe appliquée à la montre. Il peut donc être nécessaire de resynchroniser la position des aiguilles d'heures et de minutes.

Dans ce contexte, on comprend qu'il existe un besoin de trouver une solution, qui ne présente pas les inconvénients de l'art antérieur.

### Résumé de l'invention

L'invention a pour but de pallier ces inconvénients en proposant une montre pourvue d'un cadran comportant un dispositif de détermination de la position d'au moins une aiguille qui soit autonome et qui présente une efficacité qui reste constante dans le temps.

Un aspect de l'invention concerne un cadran de montre comprenant un dispositif de détermination de la position d'au moins une aiguille de cette montre, un tel cadran comprend une face visible et une face cachée ledit cadran étant formé par un empilement de couches minces de matière s'étendant entre ces deux faces, chacune desdites couches comprenant un ou plusieurs des éléments fonctionnels compris dans ledit dispositif de détermination :
- au moins un élément de détection de lumière,
- au moins une première source lumineuse et au moins une deuxième source lumineuse,
- une unité d'alimentation électrique autonome comprenant un module photovoltaïque, et
- une unité de contrôle pour gérer le fonctionnement de chaque une source lumineuse et dudit au moins un élément de détection de lumière.

Dans d'autres modes de réalisation :
- le cadran comprenant un trou traversant configuré pour recevoir un axe prévu pour porter ladite au moins une aiguille de la montre ;
- l'empilement de couches minces de matière est constitué d'une première couche pourvue de la face visible du cadran et comprenant ledit au moins un élément de détection de lumière et les première et deuxième sources lumineuses ;
- l'empilement de couches minces comporte une deuxième couche comprenant le module photovoltaïque ;
- ladite au moins une première source lumineuse et ledit au moins un élément de détection de la lumière sont agencés de façon qu'un faisceau lumineux émis par ladite au moins une première source lumineuse, est réfléchi par ladite au moins une aiguille en direction dudit au moins un élément de détection de la lumière ;
- ladite au moins une première source lumineuse est configurée pour émettre un faisceau lumineux vers une zone réfléchissante de ladite au moins une aiguille, ladite zone réfléchissante étant configurée pour réfléchir ce faisceau lumineux en direction dudit au moins un élément de détection de la lumière ;
- la zone réfléchissante comprend une surface réfléchissante inclinée qui est formée dans une face inférieure de ladite au moins une aiguille ;
- la zone réfléchissante comprend un réseau de diffraction formé dans une face inférieure de ladite au moins une aiguille, ledit réseau étant configuré pour réfléchir un faisceau lumineux en direction dudit au moins un élément de détection de la lumière ;
- ladite au moins une première source lumineuse est une source laser à émission de surface et à cavité verticale ;
- ladite au moins une deuxième source lumineuse est apte à générer un message visuel en fonction de la position déterminée de ladite au moins une aiguille ;
- ladite première couche est configurée pour être traversé en tout ou partie par un rayonnement lumineux notamment par un rayonnement solaire et un rayonnement lumineux émis par les première et deuxième sources lumineuses ;
- la deuxième couche comprend un substrat sur lequel le module photovoltaïque est imprimé ;
- ledit module photovoltaïque est disposé sur une zone active de ladite deuxième couche, ladite zone étant configurée pour recevoir des rayonnements lumineux provenant de la première couche de l'empilement de couches minces ;
- l'empilement de couches minces comporte une troisième couche comprenant un accumulateur d'énergie électrique constituant l'unité d'alimentation électrique autonome ;
- la troisième couche comprend un substrat sur lequel l'accumulateur d'énergie électrique est imprimé ;
- l'empilement de couches minces comporte une quatrième couche formant la face cachée du cadran comprenant l'unité de contrôle ;
- l'empilement de couches minces comporte une troisième couche comprenant la face cachée du cadran comportant l'unité de contrôle et un accumulateur d'énergie électrique constituant l'unité d'alimentation électrique autonome ;
- la première couche est rigide relativement aux autres couches comprises dans l'empilement qui sont souples.

Un autre aspect de l'invention concerne une montre comprenant un tel cadran.

Avantageusement, la montre comprend un mouvement horloger mécanique ou électromécanique.

### Brève description des figures

Les buts, avantages et caractéristiques de la montre selon l'invention apparaîtront mieux dans la description suivante sur la base d'au moins une forme d'exécution non limitative illustrée par les dessins sur lesquels :
- la figure 1 représente une vue en perspective d'une montre comprenant un cadran pourvu d'un dispositif de détermination autonome de la position d'au moins une aiguille de la montre, selon des modes de réalisation de l'invention ;
- la figure 2 représente une vue éclatée d'une première variante du cadran formé d'un empilement de quatre couches superposées, lesdites couches comportant chacune un ou plusieurs éléments constitutifs du dispositif de détermination, selon un premier mode de réalisation de l'invention ;
- la figure 3 représente une vue schématique de cette première variante du cadran pourvue du dispositif de détermination autonome selon le premier mode de réalisation de l'invention ;
- la figure 4 représente une vue éclatée d'une deuxième variante du cadran formé d'un empilement de trois couches superposées, lesdites couches comportant chacune un ou plusieurs éléments constitutifs du dispositif de détermination selon un deuxième mode de réalisation de l'invention ;
- la figure 5 représente une vue schématique de cette deuxième variante du cadran pourvue du dispositif de détermination autonome, selon le deuxième mode de réalisation de l'invention, et
- les figures 6 et 7 représentent des vues schématiques du cadran et d'une aiguille de la montre, l'aiguille comprenant une face inférieure pourvue d'une zone réfléchissante d'un faisceau lumineux émis par une première source lumineuse vers un élément de détection de lumière, selon les modes de réalisation de l'invention.

### Description détaillée de l'invention

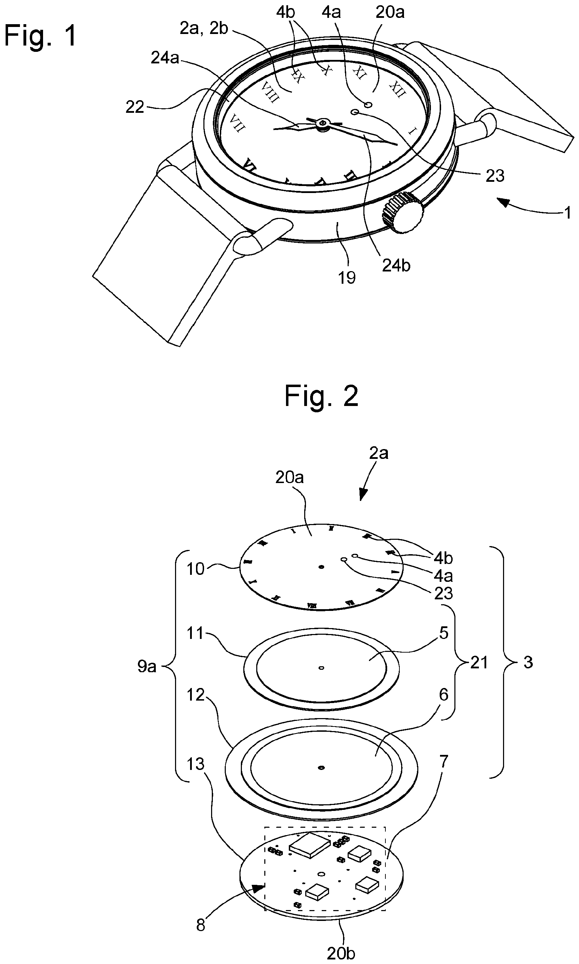

La figure 1 illustre une représentation schématique d'une montre 1 comprenant un boitier 19 pourvu d'une carrure à laquelle sont fixés un fond et une glace 22, d'un ensemble de composants formant un mouvement horloger, et d'un cadran 2a, 2b disposé entre le mouvement horloger et la glace 22.

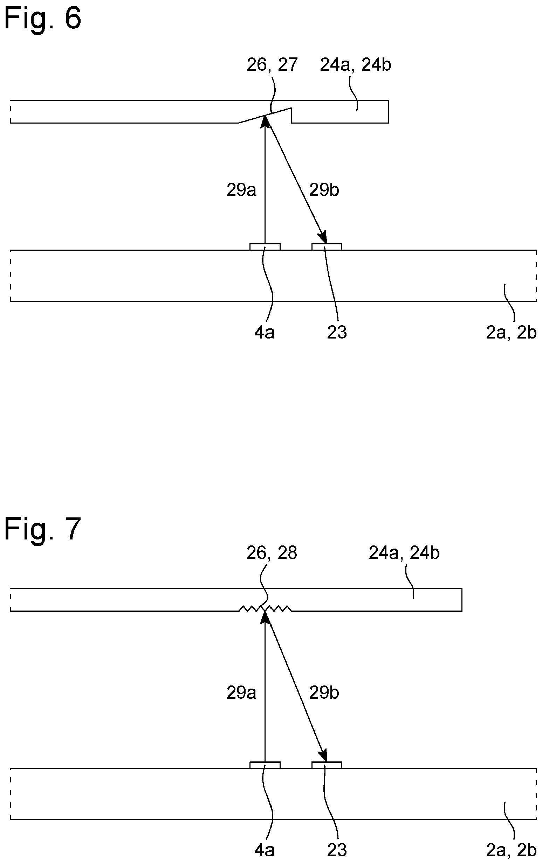

Le mouvement horloger entraîne de façon connue de l'homme du métier un aiguillage comprenant une aiguille des heures 24a, une aiguille des minutes 24b et éventuellement une aiguille des secondes. À cet effet, le cadran 2a, 2b comporte un trou traversant recevant l'axe 25 des aiguilles. Ces aiguilles 24a, 24b comprenant chacune une face inférieure réfléchissante agencée en regard du cadran 2a, 2b. Cette face inférieure est en tout ou partie réfléchissante. En particulier, en référence aux figures 6 et 7, cette face inférieure comprend une zone réfléchissante 26 incluant une surface inclinée 27 ou encore un réseau de diffraction 28.

Un tel cadran 2a, 2b comprend aussi deux faces 20a, 20b :
- une face dite visible 20a de l'extérieur de la montre 1 aussi appelée « partie visible » ou « partie supérieure visible » de ce cadran 2a, 2b, et
- une face dite cachée 20b agencée en regard du mouvement horloger dans une enceinte du boitier 19 de la montre 1, cette face 20b étant autrement appelée « partie cachée » ou « partie inférieure cachée » de ce cadran 2a, 2b.

Une telle face visible 20a peut comprendre de manière non limitative et non exhaustive au moins une représentation graphique telle que :
- un élément de repère (ou d'affichage) comme par exemple un chiffre, un index, un trait ou encore un point contribuant à participer avec/sans les aiguilles à l'affichage d'une information/grandeur horlogère ou d'une information/grandeur physique mesurée par un capteur ou similaire compris dans le mouvement ;
- une inscription, un motif, un texte, un logo, etc.

Ces faces visible 20a et cachée 20b sont sensiblement planes et/ou parallèles et/ou opposées l'une à l'autre. Elles sont aussi reliées entre elles par une paroi périphérique de ce cadran 2a, 2b.

On notera par ailleurs que dans les modes de réalisation illustrés sur les figures 1 à 7, le cadran 2a, 2b a de préférence une forme circulaire. On comprend que l'invention peut également être mise en oeuvre pour des cadrans 2a, 2b ayant d'autres formes comme par exemple une forme triangulaire ou encore une forme similaire à celle d'un quadrilatère.

Dans les modes de réalisation de l'invention, le mouvement horloger est un mouvement mécanique. Dans une alternative ce mouvement peut être un mouvement électromécanique. On parlera d'ailleurs par la suite d'une montre mécanique lorsque son mouvement est mécanique et d'une montre électromécanique lorsque son mouvement est électromécanique.

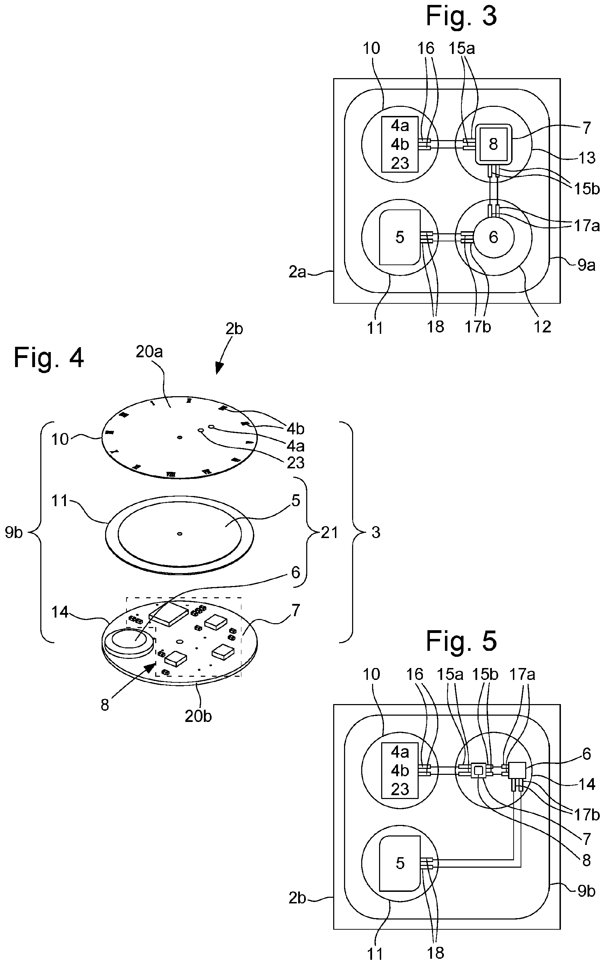

En référence aux figures 2 et 4, un tel cadran 2a, 2b comprend un dispositif de détermination autonome 3 d'une position d'au moins une aguille 24a, 24b de la montre 1. Ce dispositif de détermination 3 comprend ses propres moyens d'alimentation électrique comme nous le verrons par la suite. Un tel dispositif de détermination 3 est dit autonome notamment par rapport au mouvement de la montre 1 et en particulier de la source énergétique de ce mouvement, par exemple lorsque cette source est une alimentation électrique comme dans un mouvement électromécanique. Dans ces conditions, on comprend que l'énergie utilisée par ce dispositif de détermination 3 ne se fait pas au détriment de l'autonomie du mouvement.

Dans ce contexte, le cadran 2a, 2b peut être monté de manière amovible dans la montre 1 quel que soit le type de la montre 1. La seule condition à respecter est que le cadran 2a, 2b comprenne ce dispositif de détermination 3 qui est donc autonome par rapport au mouvement de la montre1. Ce cadran 2a, 2b est aussi appelé « cadran autonome » car il n'est pas connecté notamment électriquement au mouvement de la montre 1. Ce cadran 2a, 2b peut être considéré comme une pièce rapportée à la montre 1.

Ce dispositif de détermination 3 compris dans ce cadran 2a, 2b, comporte des sources lumineuses 4a, 4b aussi appelées sources de lumière, une unité d'alimentation électrique autonome 21, au moins un élément de détection de lumière 23 et une unité de contrôle 7.

Parmi ces sources lumineuses 4a, 4b, on trouve au moins une première source lumineuse 4a qui participe à l'évaluation de la position d'au moins une aiguille 24a, 24b de la montre 1 en coopérant avec ledit au moins un élément de détection 23. Comme on le verra par la suite, cette première source lumineuse 4a et l'élément de détection 23, sont agencés sous la face visible 20a du cadran 2a, 2b ou sur cette face visible 20a. Dans cette configuration, cette première source lumineuse 4a est alors apte à émettre un faisceau lumineux 29a en direction de l'aiguille 24a, 24b qui se déplace au-dessus de la face visible 20a, ladite aiguille 24a, 24b étant apte à réfléchir ce faisceau 29a, selon un faisceau lumineux 29b, en direction de l'élément de détection 23. Une telle première source lumineuse 4a est de préférence une source laser à émission de surface et à cavité verticale, mieux connue sous sa dénomination anglo-saxonne Vertical Cavity Surface Emission Laser ou VCSEL.

On trouve aussi parmi ces sources de lumineuse 4a, 4b, au moins une deuxième source lumineuse 4b qui est mise en oeuvre notamment pour participer à l'affichage d'un message visuel en rapport avec la détermination de la position de l'aiguille 24a, 24b. Cette deuxième source lumineuse 4b inclut de préférence n'importe quel élément électroluminescent sélectionné dans une liste comprenant de manière non exhaustive et non limitative :
- un condensateur électroluminescent plus connu sous l'acronyme LEC pour « Light-Emitting Capacitor » ;
- une diode électroluminescente de type LED (acronyme de « Light-Emitting Diode »), OLED (acronyme de « Organic Light-Emitting Diode »), AMOLED (acronyme de « Active-Matrix Organic Light-Emitting Diode ») ou encore QLED (acronyme de « Quantum Light-emitting diode » ;
- tout matériau électroluminescent activé par un champ électrique local ;
- tout matériau électroluminescent activé par un courant électrique ;
- toutes combinaisons de ces éléments électroluminescents.

On notera que cette deuxième source lumineuse 4b peut dans certains modes de réalisation de l'invention, être une source lumineuse 4b apte à former une source lumineuse étendue. Ceci permet de donner une forme prédéterminée à la source lumineuse étendue, typiquement, sans que cela ne soit exhaustif ni limitatif, une forme relative à une représentation graphique de chiffre, de lettre, de logo ou encore de texte. On notera en complément, que cette deuxième source lumineuse 4b peut produire de la lumière dans n'importe quelle couleur et/ou dans n'importe quelle direction.

Dans ce dispositif de détermination 3, l'unité d'alimentation électrique autonome 21 comporte un accumulateur d'énergie électrique 6 et un module photovoltaïque 5 comprenant au moins une cellule photovoltaïque encore appelée cellule solaire. Ce module photovoltaïque 5 est relié à l'accumulateur d'énergie électrique 6 via des éléments de connexions référencés 17b et 18 sur les figures 3 et 5. Ce module photovoltaïque 5 peut comprendre une ou des cellules élémentaires du type à hétérojonction ou multijonction, connectées en parallèle ou en série. Chaque cellule photovoltaïque de ce module 5, peut être réalisée, de manière connue de l'homme du métier, à partir de matériaux semi-conducteurs à base de cuivre, d'indium, de gallium et de sélénium, à base de tellurure de cadmium, à base d'arséniure de gallium monocristallin ou à base de silicium monocristallin ou polycristallin, ou à pérovskites. Il y a lieu de noter que ces exemples sont non limitatifs et que l'homme du métier saura trouver le type de cellule photovoltaïque adapté à l'invention.

Dans ce dispositif de détermination 3, l'unité de contrôle 7 aussi appelée microcontrôleur, comporte un circuit électronique 8 comprenant des ressources matérielles en particulier au moins un processeur coopérant avec des éléments de mémoire ainsi que des bus d'adresses, de données et de contrôle. Cette unité de contrôle 7 est connectée audites première et deuxième sources lumineuses 4a, 4b, audit au moins un élément de détection de lumière 23 et à l'unité d'alimentation électrique autonome 21. Cette unité de contrôle 7 comprend dans ses éléments de mémoire un algorithme de gestion de la position d'au moins une aiguille 24a, 24b de la montre. Un tel algorithme est exécuté par le processeur de cette unité de contrôle 7 en tenant compte notamment de données de mesure d'intensité lumineuse provenant dudit au moins un élément de détection de lumière 23 compris dans le dispositif de détermination 3. Un tel algorithme participe à :
- déterminer cette position,
- générer le message visuel en fonction de la position déterminée de l'aiguille 24a, 24b,
- piloter ladite deuxième source de lumineuse 4b,
- mettre en oeuvre au moins une fonction de la montre requérant la position déterminée de l'aiguille.

On notera que le dispositif de détermination 3 peut comprendre au moins un capteur d'évènement permettant d'affiner la détermination de cette position de l'aiguille 24a, 24b et aussi de participer à l'affichage dudit message visuel. Ce capteur peut ainsi générer des données qui seront alors utilisées par cet algorithme. De telles données peuvent comprendre des informations relatives à des évènements détectés par ce capteur, lesdits évènements étant susceptibles de contribuer au fonctionnement desdites première et deuxième sources lumineuse 4a, 4b. Ces évènements peuvent comprendre de manière non limitative et non exhaustive : la détection d'un niveau de luminosité particulier dans l'environnement de la montre 1, la détection d'un élément sonore particulier ou d'un niveau sonore particulier, la détection d'un objet visuel particulier, la détection d'un mouvement effectué par une partie du corps de l'utilisateur sur laquelle est comprise cette montre 1, etc.

Dans ce contexte, le capteur d'évènement de ce dispositif de détermination autonome 3, peut comprendre en particulier et de manière non limitative et non exhaustive :
- un capteur de luminosité permettant de détecter le niveau de luminosité ambiante ;
- un capteur de mouvement d'une partie du corps de l'utilisateur comprenant la montre 1 tel qu'un capteur gyroscopique et/ou inertiel sous la forme d'un composant électronique de type circuit microsystèmes électromécaniques gyroscopique et/ou inertiel ;
- un capteur sonore de type microphone, et/ou
- un capteur optique de type capteur photographique.

Par ailleurs, lorsque le dispositif de détermination 3 comprend plusieurs deuxièmes sources lumineuses 4b, le fonctionnement de ces dernières peut alors être géré/contrôlé par l'unité de contrôle 7 de manière simultanée et/ou en séquence. De plus chaque deuxième source lumineuse 4b est gérée/contrôlée par cette unité de contrôle 7 de manière distincte. Dans ce contexte, la gestion du fonctionnement de chaque deuxième source lumineuse 4b, peut consister de manière non limitative et non exhaustive en la réalisation des opérations suivantes : un allumage ou une extinction séquentiel (le), un allumage ou une extinction simultané (e) de deux ou plusieurs deuxièmes sources lumineuses 4b, un clignotement d'une ou de plusieurs deuxièmes sources lumineuses 4b, une définition d'une fréquence de clignotement pour chaque deuxième source lumineuse 4b, une durée de clignotement pour chaque deuxième source lumineuse 4b, une durée d'allumage ou d'extinction pour chaque deuxième source lumineuse 4b, etc.

Une telle unité de contrôle 7 peut aussi comprendre dans ses éléments de mémoire un algorithme de gestion de l'accumulateur d'énergie électrique 6 en particulier la gestion de son rechargement par le module photovoltaïque 5 et la gestion de la consommation électrique desdites source lumineuses 4a, 4b et aussi dudit au moins un élément de détection de lumière 23.

Ainsi que nous l'avons évoqué, le dispositif de détermination autonome 3 est donc compris dans le cadran 2a, 2b. Dans cette configuration, les éléments constitutifs de ce dispositif de détermination 3 à savoir les première et deuxième sources lumineuses 4a, 4b, l'accumulateur d'énergie électrique 6, le module photovoltaïque 5, ledit au moins un élément de détection de lumière 23 et l'unité unité de contrôle 7, sont compris dans une ou plusieurs couches 10, 11, 12, 13, 14 formant ce cadran 2a, 2b.

En référence aux figures 2 à 5, ce cadran 2a, 2b est constitué ou formé par un empilement 9a, 9b de couches minces/fines 10, 11, 12, 13 de matière, ces couches 10, 11, 12, 13, 14 étant reliées entre elles par un élément de liaison tel qu'une substance adhésive de manière à les unifier afin obtenir un empilement 9a, 9b de couches monolithique formant ainsi un cadran monobloc 2a, 2b. Cet élément de liaison peut aussi être un clip ou encore une vis. De telles couches 10, 11, 12, 13, 14 sont superposées dans l'empilement 9a, 9b c'est-à-dire qu'elles sont agencées les unes au-dessus des autres dans ce cadran 2a, 2b selon un ordre défini. On notera qu'un tel empilement 9a, 9b de couches peut aussi être appelé un assemblage de couches. Dans cet empilement 9a, 9b, les couches sont sensiblement similaires en présentant des surfaces supérieures et inférieures sensiblement de mêmes aires/superficies participant ainsi à former la paroi périphérique du cadran 2a, 2b qui est dépourvue de relief.

On notera que ces couches minces ou fines sont des couches qui présentent chacune une épaisseur micrométrique. En effet, chaque couche peut présenter une épaisseur comprise entre 1 et 100 µm, de préférence 2 µm, ou de préférence 3 µm. S'agissant de l'épaisseur du cadran 2a, 2b, il peut être compris entre 8 et 400 µm, de préférence 6 µm ou de préférence 12 µm ou de préférence 100 µm ou de préférence 200 µm ou de préférence 300 µm.

Ainsi un tel cadran monobloc 2a, 2b, présente en outre l'avantage de pouvoir être monté de manière amovible dans le boitier 19 de la montre 1 en plus de faciliter son intégration dans ce boitier 19.

Dans une première variante de cet empilement 9a illustré sur la figure 3, il est constitué ou formé de quatre couches minces/fines 10, 11, 12, 13 successives suivantes :
- une première couche 10 formant/constituant la face visible 20a du cadran 2a incluant ladite au moins une première source lumineuse 4a, ladite au moins une deuxième source lumineuse 4b et ledit au moins un élément de détection de la lumière 23 du dispositif de détermination 3 ;
- une deuxième couche 11 incluant le module photovoltaïque 5 ;
- une troisième couche 12 incluant un accumulateur d'énergie électrique 6 aussi appelé batterie rechargeable, et
- une quatrième couche 13 formant la face cachée 20b du cadran 2a incluant l'unité de contrôle 7.

La première couche 10 de cet empilement 9a, est de préférence rigide ou semi-rigide en comparaison avec les deuxième, troisième et quatrième couches 11, 12, 13 qui sont de préférences souples ou flexibles. On comprend ici qu'une telle première couche 10 participe à rigidifier de manière structurelle l'empilement 9a et donc le cadran 2a.

Dans cet empilement 9a, les première, deuxième, troisième et quatrième couches 10, 11, 12, 13, comprennent chacune une surface supérieure et une surface inférieure.

S'agissant de la première couche 10, elle est formée par un substrat transparent ou translucide ou au moins partiellement transparent ou au moins partiellement translucide qui est rigide ou semi-rigide. Un tel substrat est réalisé en une matière présentant une transmittance aux rayonnements solaires en particulier aux rayonnements ultraviolets aussi appelée UVT (pour « Ultra-Violet Transmission ») qui est comprise entre 65 et 95 pourcent. Cette transmittance est de préférence de 85 pourcent. Une telle matière peut être transparente ou translucide. Cette matière peut être de manière non limitative et non exhaustive un polymère, du verre ou encore de la céramique.

Dans ce contexte, on comprend que ce substrat est configuré pour que :
- la lumière produite par les première et deuxième sources lumineuses 4a, 4b puisse s'échapper vers l'extérieur du cadran 2a, 2b et donc de la montre 1, et
- la lumière provenant de l'environnement de la montre 1 puisse pénétrer dans le cadran 2a, 2b en direction du module photovoltaïque 5 du dispositif de détermination 3, cette lumière comprenant des rayonnements solaires lorsqu'elle est d'origine naturelle.

Autrement dit, ce substrat transparent ou translucide est configuré pour être traversé par ladite lumière susceptible d'alimenter le module photovoltaïque 5 afin que ce dernier puisse convertir l'énergie solaire provenant de ce rayonnement en énergie électrique.

Cette première couche 10 comprend aussi des première et deuxième sources lumineuses 4a, 4b qui sont agencées dans le corps du substrat.

Un tel agencement de ladite au moins une première source lumineuse 4a dans/sur ce substrat est configuré pour assurer l'émission du faisceau lumineux 29a vers le haut en direction de ladite au moins une aiguille 24a, 24b. Cette première source lumineuse 4a peut être agencée sur ou sous la surface supérieure de ce substrat formant la première couche 10. Lorsqu'elle est agencée dans le substrat, cette première source lumineuse 4a est positionnée dans une cavité borgne ménagée dans cette face supérieure. Dans une variante, elle peut être agencée dans une cavité borgne réalisée dans la face inférieure de ce substrat ayant pour fond cette face supérieure. Dans cette configuration, le faisceau lumineux 29a susceptible d'être émis par cette première source lumineuse 4a traverse alors ce fond avant d'atteindre l'aiguille 24a, 24b.

Un tel agencement de ladite au moins une deuxième source lumineuse 4b dans ce substrat est configuré pour assurer un éclairage de tout ou partie de la face visible 20a du cadran 2a afin de participer notamment à l'affichage du message visuel qui est fonction de la position déterminée de l'aiguille 24a, 24b. Par exemple, un éclairage d'une représentation graphique relative à cette position telle qu'un motif, un chiffre ou une lettre, et/ou une représentation graphique telle qu'un élément de repère (ou affichage) comme un chiffre, un index, un trait, un point ou un éclairage d'une ou de plusieurs aiguilles, ou encore un éclairage de tout ou partie de la surface de la face visible du cadran 2a. Dans une variante, cette deuxième source lumineuse 4b peut avoir une forme prédéterminée telle que la forme d'un chiffre, d'une lettre, d'un index, d'un trait, d'un point, d'un logo ou encore d'un texte.

Cet éclairage peut être un éclairage de type rétroéclairage ou semi-direct lorsque la deuxième source lumineuse 4b est agencée dans une cavité définie dans le substrat. Plus précisément, cette cavité pouvant être une ouverture borgne réalisée dans la surface inférieure de ce substrat. Dans cette configuration, lorsque le fond de cette cavité comprend une représentation graphique, le rayonnement lumineux, ou la lumière, produit par cette deuxième source lumineuse 4b peut s'échapper vers l'extérieur du cadran 2a via la face visible 20a de ce cadran 2a, autorisant ainsi la visualisation d'au moins une représentation graphique dans l'obscurité. En particulier, le rayonnement lumineux en s'échappant ainsi de la face visible 20a, vient dessiner le contour de cette représentation graphique. Dans ce contexte, cette représentation graphique comprise dans ou sur la surface supérieure ou encore sur la surface inférieure du substrat formant la première couche 10, est de préférence opaque ou non translucide ou non transparente.

Cet éclairage peut être un éclairage direct lorsque la deuxième source lumineuse 4b est agencée dans une cavité définie dans le substrat. Cette cavité peut être une ouverture borgne réalisée dans la surface inférieure de ce substrat et dont le fond est dépourvu de toute représentation graphique. Dans cette configuration, le rayonnement lumineux, ou la lumière, produit par cette deuxième source lumineuse 4b peut s'échapper par le fond de cette cavité vers l'extérieur du cadran 2a et donc par la face visible 20a de ce cadran 2a.

Cet éclairage peut aussi être un éclairage direct lorsque la deuxième source lumineuse 4b est agencée dans une ouverture traversante s'étendant dans l'épaisseur du substrat de la première couche 10, en débouchant en ses deux extrémités respectivement dans les surfaces supérieure et inférieure de ce substrat. Dans cette configuration, tout ou partie de la deuxième source lumineuse 4b peut faire saillie de la surface supérieure de ce substrat et donc de la première couche 10 ou de la face visible 20a du cadran 2a pour former une représentation graphique telle qu'un index, un chiffre, un point, un trait, etc.

Un tel éclairage peut également être un éclairage déporté lorsque ladite au moins deuxième source lumineuse 4b est couplée à au moins un guide d'onde. Ce guide d'onde encore appelé guide de lumière, permet d'amener la lumière depuis le point où elle injectée dans le guide jusque dans le substrat ou jusqu'à une zone du substrat (p. ex. : cavité, ouverture traversante) proche de la surface supérieure de ce substrat. Un tel guide de lumière peut être une fibre optique qui permet de contourner les éventuels obstacles qui peuvent se dresser dans le substrat par exemple entre l'élément électroluminescent et la zone du substrat proche de la surface supérieure de ce substrat, par laquelle la lumière va s'échapper. Dans cette variante de réalisation, c'est donc la lumière qui est amenée, via le guide d'onde, depuis l'élément électroluminescent jusqu'à cette zone du substrat à éclairer.

Dans une telle configuration, une première extrémité du guide d'onde est couplée avec la deuxième source lumineuse 4b et une deuxième extrémité de ce guide peut être agencée dans :
- une cavité pouvant être une ouverture borgne réalisée dans la surface inférieure du substrat de cette première couche 10, ou
- une ouverture traversante s'étendant dans l'épaisseur du substrat de la première couche 10 en débouchant en ses deux extrémités respectivement dans les surfaces supérieure et inférieure de ce substrat et donc de la première couche 10. Ainsi cette deuxième extrémité peut faire saillie de la surface supérieure du substrat ou de cette première couche 10 ou de la face visible 20a du cadran 2a afin par exemple de former une représentation graphique de ce cadran 2a comme par exemple un élément de repère tel qu'un index, un chiffre, un point, un trait, etc.

Dans ce contexte, l'éclairage indirect peut être réalisé par une seule deuxième source lumineuse 4b comprise sur la surface inférieure du substrat de cette première couche 10 en étant couplée à plusieurs guides d'onde dont les deuxièmes extrémités sont agencées dans :
- des cavités émettant chacune un rayonnement lumineux, provenant de cette deuxième source lumineuse 4b, ce rayonnement s'échappant vers l'extérieur du cadran 2a via la face visible 20a en autorisant ainsi la visualisation d'au moins une représentation graphique dans l'obscurité. Dans ce contexte, cette représentation graphique comprise dans ou sur la face visible 20a du cadran 2a, ou la surface supérieure du substrat, est de préférence opaque, et/ou
- des ouvertures traversantes en faisant saillie ou pas de la surface supérieure de ce substrat afin de former des éléments de repères tels qu'un index, trait ou encore un point, et émettant chacune un rayonnement lumineux, provenant de cette deuxième source lumineuse 4b.

Dans cette première couche 10, la deuxième source lumineuse 4b est appliquée/fixée sur la surface inférieure du substrat de cette première couche 10, dans une cavité ou sur une paroi interne d'une ouverture traversante évoquée précédemment et ce, par impression ou évaporation.

Dans cette première couche 10, l'élément de détection 23 de la lumière est disposé dans/sur ce substrat relativement à la première source lumineuse 4a afin de pouvoir recevoir le faisceau lumineux 29b réfléchi par l'aiguille 24a, 24b qui a été émis par cette source de lumière 4a. Cet élément de détection 23 peut être agencé sur ou sous la surface supérieure de ce substrat formant la première couche 10. Lorsqu'il est agencé dans le substrat, cet élément de détection 23 est positionné dans une cavité borgne ménagée dans cette face supérieure. Dans une variante, il peut être agencé dans une cavité borgne réalisée dans la face inférieure de ce substrat ayant pour fond cette face supérieure. Dans cette configuration, le faisceau lumineux 29b réfléchi par l'aiguille traverse alors ce fond avant d'atteindre ledit élément de détection 23.

En outre, on notera que la surface inférieure de cette première couche 10 peut être autocollante afin de participer à son assemblage avec la deuxième couche 11.

Dans cet empilement 9a, la deuxième couche 11 comprend un substrat comportant le module photovoltaïque 5. Un tel substrat est de préférence flexible ou souple. Ce substrat de la deuxième couche 11, peut être un film sur lequel est disposé le module photovoltaïque 5. Enfin, ce substrat peut être réalisé en un matériau appartenant à la famille des polymères.

Dans cette deuxième couche 11, le module photovoltaïque 5 s'étend préférentiellement sur l'ensemble d'une zone dite active de la surface supérieure de ce substrat. Cette zone active est une portion de la surface supérieure du substrat qui est apte recevoir la lumière provenant de la surface inférieure de la première couche 10 du cadran 2a. Cette lumière qui a traversé tout ou partie de la première couche 10, provient de l'environnement extérieur du cadran 2a, et donc de la montre 1, ici principalement du rayonnement solaire lorsqu'elle est d'origine naturelle.

On notera que le module photovoltaïque 5 est appliqué sur la surface supérieure de ce substrat à partir de procédés d'impression par jet d'encre ou encore par sérigraphie ou à partir de procédés d'impression par évaporation thermique. On parlera d'ailleurs ici d'une deuxième couche 11 comprenant un module photovoltaïque 5 imprimé. En particulier, d'un module photovoltaïque 5 imprimé sur le substrat de la deuxième couche 11.

On remarquera qu'une fois le module photovoltaïque 5 a été appliqué sur le substrat, une couche d'une substance autocollante peut être déposée surtout ou partie de la surface supérieure et/ou de la surface inférieure du substrat. Dans ces conditions, la deuxième couche 11 peut être une couche autocollante qui participe à faciliter son assemblage avec les autres couches en particulier avec la première couche 10 et/ou la troisième couche 12 de cet empilement 9a.

Dans l'empilement 9a, cette troisième couche 12 comprend aussi un substrat de préférence flexible ou souple, comportant l'accumulateur d'énergie électrique 6 du dispositif de détermination autonome 3. Ce substrat de la troisième couche 12 peut être un film sur lequel est compris l'accumulateur 6. Un tel substrat peut être réalisé en un matériau appartenant à la famille des polymères.

Cet accumulateur 6 peut être une batterie au lithium ou encore une batterie à semi-conducteurs. Un tel accumulateur 6 est appliqué sur la surface supérieure de ce substrat à partir de procédés connus de l'état de la technique tels que :
- des procédés d'impression sur substrat polymère souple lorsqu'il s'agit par exemple d'une batterie au lithium, ou
- des procédés d'impression tridimensionnelle lorsqu'il s'agit par exemple d'une batterie à semi-conducteurs telle qu'une batterie lithium-métal à semi-conducteurs.

On parlera d'ailleurs ici d'une troisième couche 12 comprenant un accumulateur d'énergie électrique 6 imprimé. En particulier, d'un accumulateur d'énergie électrique 6 imprimé sur le substrat de la troisième couche 12.

Ainsi, de tels procédés permettent d'obtenir une troisième couche 12 comprenant cet accumulateur 6 qui est souple et ultrafine.

En outre, on remarquera qu'une fois l'accumulateur 6 appliqué sur le substrat, une couche d'une substance autocollante peut être déposée surtout ou partie de la surface supérieure et/ou de la surface inférieure de ce substrat. Dans ces conditions, la troisième couche 12 peut être une couche autocollante qui participe à faciliter son assemblage avec les autres couches en particulier avec la deuxième couche 11 et/ou la quatrième couche 13 de cet empilement 9a.

On notera que cet accumulateur 6 sert à stocker l'énergie électrique produite par le module photovoltaïque 5 et à la restituer sur demande pour alimenter le dispositif de détermination 3, notamment les première et deuxième sources lumineuses 4a, 4b et ledit au moins un élément de détection 23.

Dans cet empilement 9a, cette quatrième et dernière couche 13 forme la face cachée du cadran 2a. Une telle quatrième couche 13 est formée par un substrat de préférence flexible ou souple, comportant l'unité de contrôle 7. Un tel substrat de la quatrième couche 13, peut être par exemple un PCB flexible (acronyme de « Printed circuit board ») sur lequel est agencée cette unité de contrôle 7 en particulier sur la surface supérieure de ce PCB et donc du substrat. Dans ce contexte, l'édification de l'unité de contrôle 7 sur cette surface supérieure du substrat peut être réalisée à partir de procédés d'impression tridimensionnelle ou encore des procédés d'impression sur polymère.

Dans la deuxième variante, l'empilement 9b formant le cadran 2b, comprend trois couches minces/fines 10, 11, 14, reliées entre elles. On remarquera que cette deuxième variante se différencie de la première variante en ce qu'elle comprend donc trois couches 10, 11, 14 au lieu de quatre couches 10, 11, 12, 13, comme dans la première variante. Dans cette deuxième variante, l'accumulateur d'énergie électrique 6 du dispositif de détermination autonome 3 est maintenant compris dans la troisième et dernière couche 14 de cet empilement 9b avec l'unité de contrôle 7.

Une telle troisième et dernière couche 14 de cet empilement 9b, formant la face cachée du cadran 2b, est constituée d'un substrat de préférence flexible ou souple, sur lequel sont édifiés, de préférence sur la surface supérieure de ce substrat, l'accumulateur 6 et le circuit électronique 8 constituant l'unité de contrôle 7. Une telle édification de l'accumulateur 6 et de l'unité de contrôle 7 sur cette surface supérieure du substrat, peut être réalisée à partir de procédés d'impression tridimensionnelle ou encore des procédés d'impression sur polymère. On notera qu'un tel substrat peut être par exemple un PCB flexible.

En résumé dans cette deuxième variante, l'empilement 9b comprend alors :
- une première couche 10 formant la face visible 20a du cadran 2b incluant lesdites première et deuxième sources lumineuses 4a, 4b et ledit élément de détection 23 ;
- une deuxième couche 11 incluant le module photovoltaïque 5, et
- la troisième couche 14 formant la face cachée 20b du cadran 2b incluant l'accumulateur 6 et l'unité de contrôle 7.

On notera que dans cette deuxième variante, les première et deuxième couches 10, 11 sont similaires à celles de la première variante de l'empilement 9a.

Par ailleurs, en référence aux figures 3 et 5, le circuit électronique 8 de l'unité de contrôle 7 comprend des premiers éléments de connexion 15a qui sont reliés à des éléments de connexion 16 aux première et deuxième sources lumineuse 4a, 4b et audit au moins un élément de détection 23 pour la détermination de la position de l'aiguille et l'affichage d'un message visuel en fonction de cette position. Ce circuit électronique 8 comprend aussi des deuxièmes éléments de connexion 15b reliés à des premiers éléments de connexion 17a de l'accumulateur 6.

Dans une troisième variante non représentée, l'empilement formant le cadran comprend deux couches reliées entre elles. On remarquera que cette troisième variante se différencie de la deuxième variante en ce qu'elle comprend donc deux couches au lieu de trois couches 10, 11, 14, comme dans cette deuxième variante. Dans cette troisième variante, le module photovoltaïque 5 du dispositif de détermination autonome 3 est maintenant compris dans la première couche et en particulier sur la surface inférieure du substrat formant cette première couche. Ce module photovoltaïque 5 peut être appliqué sur cette surface inférieure du substrat de cette première couche à partir de procédés d'impression par jet d'encre ou encore par sérigraphie ou à partir de procédés d'impression par évaporation thermique. On notera donc que cette première couche est alors similaire aux premières couches 11 des première et deuxième variantes, à l'exception du fait que dans cette troisième variante, la première couche comprend en plus le module photovoltaïque.

Par ailleurs dans la troisième variante, et de manière similaire à la deuxième variante, l'accumulateur d'énergie électrique 6 du dispositif de détermination autonome 3 est compris dans la deuxième et dernière couche de cet assemblage avec l'unité de contrôle 7. Une telle deuxième couche formant la face cachée du cadran, est constituée d'un substrat de préférence flexible ou souple, sur lequel sont édifiés, de préférence sur la surface supérieure de ce substrat, l'accumulateur 6 et le circuit électronique 8 constituant l'unité de contrôle 7. Cette édification de l'accumulateur 6 et de l'unité de contrôle 7 sur la surface supérieure du substrat, peut être réalisée à partir de procédés d'impression tridimensionnelle ou encore des procédés d'impression sur polymère. On notera qu'un tel substrat peut être par exemple un PCB flexible.

En résumé dans cette troisième variante, l'empilement comprend alors :
- une première couche formant la face visible 20a du cadran incluant lesdites première et deuxième sources lumineuses 4a, 4b, ledit au moins un élément de détection 23 et le module photovoltaïque 5 du dispositif de détermination 3, et
- une deuxième couche formant la face cachée 20b du cadran incluant l'accumulateur 6 et l'unité de contrôle 7.

En outre, on notera que les capteurs d'évènements du dispositif de détermination 3, évoqués précédemment sont de préférence agencés dans la première couche 10 et/ou la dernière couche 13, 14 de l'empilement 9a, 9b de couches en étant reliés à l'unité de contrôle 7 de ce dispositif 3.

Ainsi dans ce cadran 2a, 2b, le dispositif de détermination 3 comprend de préférence dédié à chaque aiguille, l'élément de détection 23 qui mesure une intensité lumineuse. Dans une position déterminée de l'aiguille 24a, 24b, le faisceau lumineux 29a émis par la première source de lumière 4a est réfléchi par cette aiguille 24a, 24b, selon un faisceau lumineux 29b, en direction de cet élément de détection de la lumière 23. Plus précisément, ce faisceau lumineux 29a émis est réfléchi par la zone réfléchissante 26 de l'aiguille qui est définie sur sa face inférieure. Cette zone 26 comprend la surface inclinée réfléchissante 27 ou le réseau de diffraction 28 qui est formée dans cette face inférieure. Cette surface inclinée réfléchissante 27 et le réseau de diffraction 28 sont configurés pour réfléchir un tel faisceau lumineux 29a en direction de l'élément de détection 23. Dans cette configuration, l'intensité lumineuse est mesurée par cette élément 23 et transmise à l'unité de contrôle qui effectue un traitement et l'archive. Dès lors que la mesure de cette intensité augmente brusquement du fait du passage de l'aiguille au-dessus de l'élément de détection 23, l'unité de contrôle détermine alors la position de cette aiguille. Effectivement, lors de ce passage, l'élément de détection mesure une intensité lumineuse qui résulte de la réception par cet élément 23 du faisceau lumineux 29b réfléchi par la zone réfléchissante de l'aiguille. Comme l'aiguille des minutes est habituellement placée au-dessus de l'aiguille des heures, cette différence de hauteur engendre une différence d'intensité lumineuse perçue par l'élément de détection 23. Il est avantageusement possible d'identifier chacune des aiguilles avec une seule première source de lumière 4a et un seul élément de détection de la lumière 23.

Une telle détermination de la position de cette aiguille, peut permettre à ce cadran 2a, 2b de mettre en oeuvre diverses fonctions de cette montre. Par exemple, une fonction de cette montre peut correspondre à une détection d'une perte de précision du chronométrage. En effet, il peut arriver qu'en raison des chocs subis par la montre, de la présence de champs électromagnétiques ou d'autres perturbations externes, on perde des pas moteur dans le cas d'un mouvement électromécanique. Ceci a pour conséquence que, bien qu'une horloge interne de la montre fournisse une indication juste de l'heure courante, les aiguilles d'heures et de minutes fournissent une indication faussée de cette heure courante, car les rouages ont sauté de quelques pas sous l'effet de la perturbation externe appliquée à la montre. Il est donc nécessaire de resynchroniser la position des aiguilles d'heures et de minutes. Dès lors dans le cadre de cette fonction, l'unité de contrôle 7 peut générer un message visuel en fonction donc de cette position qui signale cette perte de précision par le contrôle/pilotage d'une ou de plusieurs deuxièmes sources lumineuses 4b.

D'autres fonctions de la montre utilisant la détermination de la position d'au moins une aiguille de cette dernière, peuvent prévoir une détection du nombre de passage d'une aiguille 24a, 24b au-dessus de l'élément de détection 23, par exemple chaque passage de l'aiguille des minutes 24b allume une deuxième source lumineuse 4b, par exemple en regard d'un index, dans le but de proposer un chronométrage rudimentaire d'un certain laps de temps. Le start/stop/reset (pour démarrage/arrêt/réinitialisation) pouvant être réalisé en couvrant la glace. Cette variation de luminosité étant interprétée par l'unité de contrôle 7 (via l'élément de détection de la lumière 23 ou par l'absence soudaine de production d'énergie par module photovoltaïque 5) comme signal de démarrage, d'arrêt ou de remise à zéro. Dans cet exemple, le nombre de passage de l'aiguille des heures 24a peut être comptabilisé. Après un nombre de passages donnés, la deuxième source lumineuse 4b est allumée pour signaler qu'un service d'entretien de la montre est recommandé. Après un nombre de passages supplémentaires, une deuxième couleur, ou un clignotement, peut indiquer qu'un service d'entretien est nécessaire.

Une autre fonction liée à cette détermination de la position d'au moins une aiguille de la montre, peut prévoir de participer à l'affichage du système horaire par l'indication des « Ante Meridiem (acronyme AM) » et « Post Meridiem (acronyme PM) ». Par exemple, chaque passage d'aiguille d'heure 24b au-dessus de l'élément de détection 23 allume puis éteint une deuxième source lumineuse 4b afin d'indiquer la période (matin ou après-midi) de la journée.

Une autre fonction liée à cette détermination de la position d'au moins une aiguille de la montre, peut prévoir une illumination de la position ou rétroéclairage des aiguilles 24a, 24b (en lieu et place de l'utilisation de matière luminescente). En cas de faible luminosité détectée par l'unité de contrôle 7 (via l'élément de détection de la lumière 23 ou par l'absence de production d'énergie par module photovoltaïque 5), différentes deuxièmes sources lumineuses 4b sont allumées pour indiquer la position des aiguilles. Par exemple, douze éléments de détection, chacun placé en regard d'un index peuvent détecter la position des deux aiguilles avec une précision de cinq minutes dans cette configuration. L'absence de détection de l'aiguille des minutes indique que les deux aiguilles sont superposées.

Une autre fonction liée à cette détermination de la position d'au moins une aiguille de la montre, peut prévoir un comptage du nombre de passage d'au moins une aiguille 24a, 24b, permettant par exemple de déterminer le temps de fonctionnement réel de cette montre 1, par exemple entre deux services de révision ou d'entretien de cette montre.

Il va de soi que la présente invention n'est pas limitée aux modes de réalisation qui viennent d'être décrits et que diverses modifications et variantes simples peuvent être envisagées par l'homme du métier sans sortir du cadre de l'invention tel que défini par les revendications annexées.

## Revendications

1. Cadran (2a, 2b) de montre (1) comprenant un dispositif de détermination (3) de la position d'au moins une aiguille (24a, 24b) de cette montre (1), un tel cadran (2a, 2b) comprend une face visible (20a) et une face cachée (20b) ledit cadran (2a, 2b) étant formé par un empilement (9a, 9b) de couches minces (10, 11, 12, 13, 14) de matière s'étendant entre ces deux faces (20a, 20b), chacune desdites couches (10, 11, 12, 13, 14) comprenant un ou plusieurs des éléments fonctionnels compris dans ledit dispositif de détermination (3) :
- au moins un élément de détection de lumière (23),
- au moins une première source lumineuse (4a) et au moins une deuxième source lumineuse (4b),
- une unité d'alimentation électrique autonome (21) comprenant un module photovoltaïque (5), et
- une unité de contrôle (7) pour gérer le fonctionnement de chaque une source lumineuse (4a, 4b) et dudit au moins un élément de détection de lumière (23).

2. Cadran (2a, 2b) selon la revendication précédente, comprenant un trou traversant configuré pour recevoir un axe (25) prévu pour porter ladite au moins une aiguille (24a, 24b) de la montre (1).

3. Cadran (2a, 2b) selon l'une quelconque des revendications précédentes, dans lequel l'empilement (9a, 9b) de couches minces (10, 11, 12, 13, 14) de matière est constitué d'une première couche (10) pourvue de la face visible (20a) du cadran (2a, 2b) et la première couche (10) comprenant ledit au moins un élément de détection de lumière (23) et les première et deuxième sources lumineuses (4a, 4b).

4. Cadran (2a, 2b) selon l'une quelconque des revendications précédentes, dans lequel l'empilement (9a, 9b) de couches minces (10, 11, 12, 13, 14) comporte une deuxième couche (11) comprenant le module photovoltaïque (5).

5. Cadran (2a, 2b) selon l'une quelconque des revendications précédentes, dans lequel ladite au moins une première source lumineuse (4a) et ledit au moins un élément de détection de la lumière (23) sont agencés de façon qu'un faisceau lumineux (29a) émis par ladite au moins une première source lumineuse (4a), est réfléchi par ladite au moins une aiguille (24a, 24b) en direction dudit au moins un élément de détection de la lumière (23).

6. Cadran (2a, 2b) selon l'une quelconque des revendications précédentes, dans lequel ladite au moins une première source lumineuse (4a) est configurée pour émettre un faisceau lumineux (29a) vers une zone réfléchissante (26) de ladite au moins une aiguille (24a, 24b), ladite zone réfléchissante (26) étant configurée pour réfléchir ce faisceau lumineux (29a) en direction dudit au moins un élément de détection de la lumière (23).

7. Cadran (2a, 2b) selon la revendication précédente, dans lequel la zone réfléchissante (26) comprend une surface réfléchissante (27) inclinée qui est formée dans une face inférieure de ladite au moins une aiguille (24a, 24b).

8. Cadran (2a, 2b) selon la revendication 6, dans lequel la zone réfléchissante (26) comprend un réseau de diffraction (28) formé dans une face inférieure de ladite au moins une aiguille (24a, 24b), ledit réseau (28) étant configuré pour réfléchir un faisceau lumineux (29a) en direction dudit au moins un élément de détection de la lumière (23).

9. Cadran (2a, 2b) selon l'une quelconque des revendications précédentes, dans lequel ladite au moins une première source lumineuse (4a) est une source laser à émission de surface et à cavité verticale.

10. Cadran (2a, 2b) selon l'une quelconque des revendications précédentes, dans lequel ladite au moins une deuxième source lumineuse (4b) est apte à générer un message visuel en fonction de la position déterminée de ladite au moins une aiguille.

11. Cadran (2a, 2b) selon l'une quelconque des revendications précédentes, dans lequel ladite première couche (10) est configurée pour être traversé en tout ou partie par un rayonnement lumineux notamment par un rayonnement solaire et un rayonnement lumineux émis par les première et deuxième sources lumineuses (4a, 4b).

12. Cadran (2a, 2b) selon l'une quelconque des revendications précédentes, dans lequel la deuxième couche (11) comprend un substrat sur lequel le module photovoltaïque (5) est imprimé.

13. Cadran (2a, 2b) selon l'une quelconque des revendications précédentes, dans lequel ledit module photovoltaïque (5) est disposé sur une zone active de ladite deuxième couche (11), ladite zone étant configurée pour recevoir des rayonnements lumineux provenant de la première couche (10) de l'empilement (9a, 9b) de couches minces (10, 11, 12, 13, 14).

14. Cadran (2a) selon l'une quelconque des revendications précédentes, **caractérisé en ce que** l'empilement (9a) de couches minces (10, 11, 12, 13) comporte une troisième couche (12) comprenant un accumulateur d'énergie électrique (6) constituant l'unité d'alimentation électrique (21) autonome.

15. Cadran (2a) selon la revendication précédente, **caractérisé en ce que** la troisième couche (12) comprend un substrat sur lequel l'accumulateur d'énergie électrique (6) est imprimé.

16. Cadran (2a) selon l'une quelconque des revendications précédentes, **caractérisé en ce que** l'empilement (9a) de couches minces (10, 11, 12, 13) comporte une quatrième couche (13) formant la face cachée (20b) du cadran (2a) comprenant l'unité de contrôle (7).

17. Cadran (2b) selon l'une quelconque des revendications 1 à 13, **caractérisé en ce que** l'empilement (9b) de couches minces (10, 11, 14) comporte une troisième couche (14) comprenant la face cachée (20b) du cadran (2b) comportant l'unité de contrôle (7) et un accumulateur d'énergie électrique (6) constituant l'unité d'alimentation électrique (21) autonome.

18. Cadran (2a, 2b) selon l'une quelconque des revendications précédentes, **caractérisé en ce que** la première couche (10) est rigide relativement aux autres couches (11, 12, 13, 14) comprises dans l'empilement (9a, 9b) qui sont souples.

19. Montre (1) comprenant un cadran (2a, 2b) selon l'une quelconque des revendications précédentes.

20. Montre (1) selon la revendication précédente, **caractérisée en ce qu'**elle comprend un mouvement horloger mécanique ou électromécanique.
